# EUROPEAN PATENT SPECIFICATION

(11) **EP 3 570 361 B1**
(45) Date of publication and mention of the grant of the patent: **10.11.2021**
(21) Application number: 18897861.3
(22) Date of filing: 06.12.2018
(51) Int. Cl.: H02J 7/00, H05K 1/00, H01M 10/46, H01M 10/48, H01M 10/42

(54) **ENERGY LEVEL CONVERSION CIRCUIT FOR PORTABLE ENERGY STORAGE DEVICE**
ENERGIENIVEAUUMSETZSCHALTUNG FÜR TRAGBARE ENERGIESPEICHERVORRICHTUNG
CIRCUIT DE CONVERSION DE NIVEAU D'ÉNERGIE POUR DISPOSITIF DE STOCKAGE D'ÉNERGIE PORTATIF

(30) Priority: 05.02.2018 KR 20180013955
(43) Date of publication of application: 20.11.2019
(73) Proprietor: Enercamp Co., Ltd., Dalseo-gu, Daegu 42601 (KR)
(72) Inventor: CHAI, Yong Yoong, Dalseo-gu Daegu 42600 (KR); CHOI, Sang Deok, Dalseo-gu Daegu 42601 (KR); CHOI, Jungsub, Dalseo-gu Daegu 42601 (KR)
(74) Representative: M. Zardi & Co S.A.
(86) International application number: PCT/KR2018/015396
(87) International publication number: WO 2019/151634

(56) References cited:
- JP-A- H05 252 657
- KR-A- 20130 096 279
- KR-A- 20140 120 025
- KR-A- 20140 140 108
- KR-Y1- 200 190 917
- US-A1- 2005 030 726
- US-A1- 2005 189 566
- US-A1- 2011 221 268

## Description

### Technical Field

The present invention relates to an energy level conversion circuit for a portable energy storage device and, more particularly, to an energy level conversion circuit for a portable energy storage device, by which energy stored in a battery or a portable energy storage device, or energy produced through a solar cell is boosted to a desired level and then converted to an AC power source in order to use various electronic products operated by the AC power source.

### Background Art

Generally, various kinds of electronic products of electric/electronic devices requiring a power source are used by connecting a commercial AC power source (for example, AC 1220V) provided by an electric company (e.g., Korean Electric Power Corporation; KEPCO) to an outlet provided in a home or office. Also, in a place where a commercial AC power source is not provided, a DC power source may be provided by using a battery integrally or detachably mounted in the electronic device instead of the commercial AC power source.

In recent years, there has been an increasing tendency to drive various electronic products using a battery in a situation where social interest in outdoors is increasing. In other words, as interest in outdoor activities increases, the population increasingly partakes in outdoor activities such as camping, fishing, and vacations. As outdoor culture such as camping changes into culture in a family unit, there is a growing tendency to use the various electronic products requiring a commercial power source.

Accordingly, there is an increasing demand for DC/AC inverters that produce commercial alternating current power source (for example, AC 1220V) using a direct current power source (e.g., DC 12V) of a battery (or solar cell). Herein, the inverter serves to convert a direct current (DC) to an alternating current (AC), and needs a DC/DC converter (i.e., an energy level conversion device) that amplifies (or boosts) (e.g., DC 400V) a level of the direct current power source of the battery (or solar cell) before the direct current is converted into the alternating current. Here, including the DC/DC converter (i.e., the energy level conversion device) and the DC/AC inverter may be referred to as an energy conversion device.

However, since the energy conversion device is mainly required for outdoor activities, it is preferable that the energy conversion device is as small as possible in volume and weight and provided in such a manner to be easily changed into a desired power (or energy) level so that it may correspond to various electronic products having different power (or energy) levels.

The background art of the present invention is disclosed in Korean Utility Application No. 20-2012-0000788 (published on February 2, 2012, Portable DC AC Power Supply). US 2011/221268 A1 discloses a power converter in which a multilayer board having a power semiconductor module and busbars is modularized.

### Disclosure

### Technical Problem

According to an aspect of the present invention, the present invention has been made keeping in mind the above problems occurring in the related art, and an object of the present invention is to provide an energy level conversion circuit for a portable energy storage device, by which an energy stored in a battery or a portable energy storage device or an energy produced through a solar cell is boosted to a desired level and then converted to an AC power source in order to use various electronic products operated by the AC power source.

### Technical Solution

The present invention provides an energy level conversion circuit according to claim 1. Preferred embodiments are defined in dependent claims. The invention is set out in the appended set of claims.

### Advantageous Effects

According to one aspect of the present invention, the present invention enables boosting energy stored in a battery or a portable energy storage device, or energy produced through a solar cell to a desired level. In addition, according to the present invention, it is possible to easily change a level of the power source into a desired power (or energy) level so that the level corresponds to various electronic products, and when a fault occurs in a sub-board, to resolve the fault through replacement thereof.

### Description of Drawings

FIG. 1 is an exemplary view illustrating a schematic configuration of a portable energy storage device according to a first embodiment of the present invention.
FIG. 2 is an exemplary view illustrating a schematic configuration of a portable energy storage device according to a second embodiment of the present invention.
FIG. 3 is an exemplary view illustrating a schematic external appearance of a portable energy storage device according to an embodiment of the present invention.
FIG. 4 is a flowchart illustrating an operation of blocking or maintaining a cable connection according to whether a control unit is connected to a load in FIG. 2.
FIG. 5 is an exemplary view illustrating a motherboard circuit in an energy level conversion circuit for a portable energy storage device according to an embodiment of the present invention.
FIG. 6 is an exemplary view illustrating sub-board circuits inserted in a plurality of female connectors formed on a motherboard in FIG. 5.
FIG. 7 is a block diagram illustrating a computing environment including a computing device suitable for use in the exemplary embodiments.

### Mode for Invention

Hereinafter, an embodiment of an energy level conversion circuit for a portable energy storage device according to the present invention will be described with reference to the accompanying drawings.

In this process, the thicknesses of the lines and the sizes of the components shown in the drawings may be exaggerated for clarity and convenience of explanation. In addition, the terms described below are defined in consideration of the functions of the present invention, which may vary depending on the intention or custom of a user or an operator. Therefore, definitions of these terms should be made based on the contents throughout this specification.

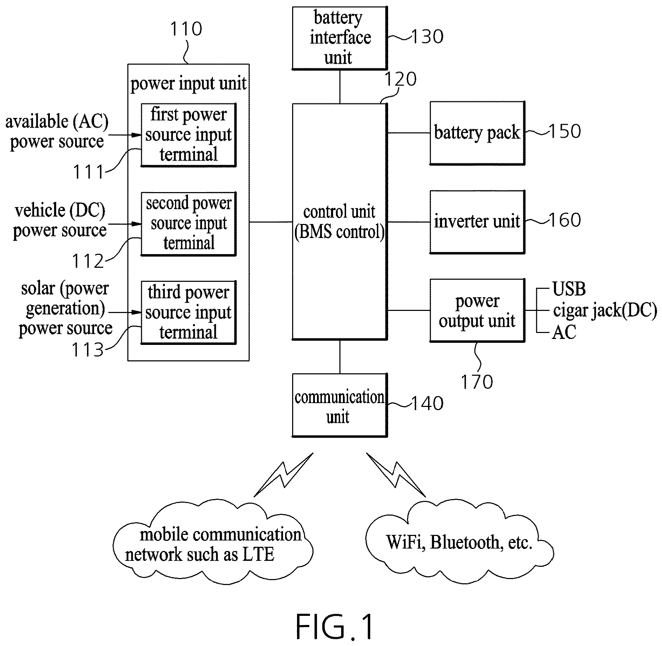

FIG. 1 is a view illustrating a schematic configuration of a portable energy storage device according to a first embodiment of the present invention.

As shown in FIG. 1, the portable energy storage device according to the first embodiment includes a power input unit 110, a control unit 120, a battery interface unit 130, a communication unit 140, a battery pack 150, an inverter unit 160, and a power output unit 170.

The power input unit 110 may receive power for charging the battery through at least three power sources (for example, a commercial power source, a vehicle power source, and a solar power source). Accordingly, the power input unit 110 may include power input units 111, 112, and 113 for the respective power sources.

The power input unit 110 is not specifically shown in the drawings, but may operate as a DC-DC converter and an AC-DC converter. That is, it is possible to convert the input power source (AC, DC) to a DC power source of the designated level.

The power output unit 170 includes output terminals for connecting power adapters (or a power supply terminal) of various loads (e.g., a notebook PC, a mobile communication terminal, a smartphone, a tablet PC, etc.) and outputs rating power sources (for example, DC5V, DC12V, DC16V, DC19V, DC24V, 110VAC, 220VAC, etc.) corresponding to each output terminal.

The control unit 120 charges the battery pack 150 using the power source input through the power input unit 110. Herein, the control unit 120 performs control on a battery management system (BMS) for stable charging.

In addition, the control unit 120 may operate based on IoT (Internet of Things). That is, the control unit 120 may operate as a smart hub which informs a user of a battery charging status and provides the user with a wireless Internet (e.g., WiFi, etc.) signal through access to a communication network using a user's portable terminal (e.g., a smart phone, a tablet PC, etc.).

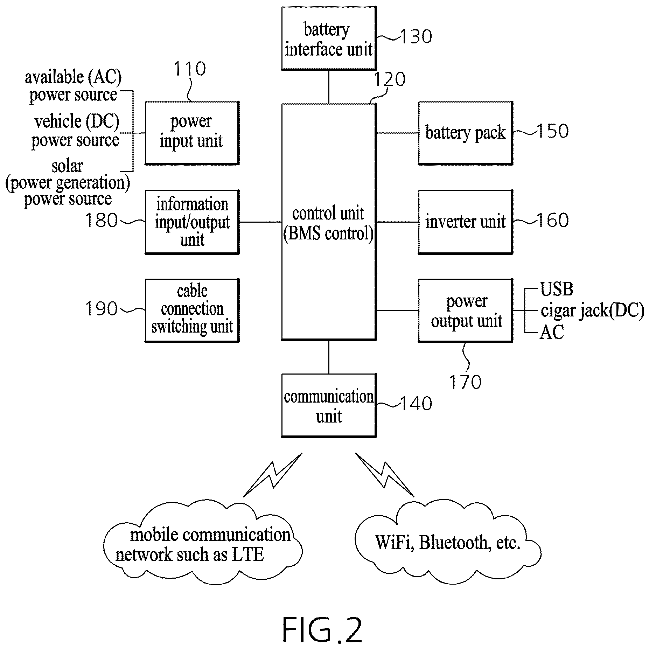

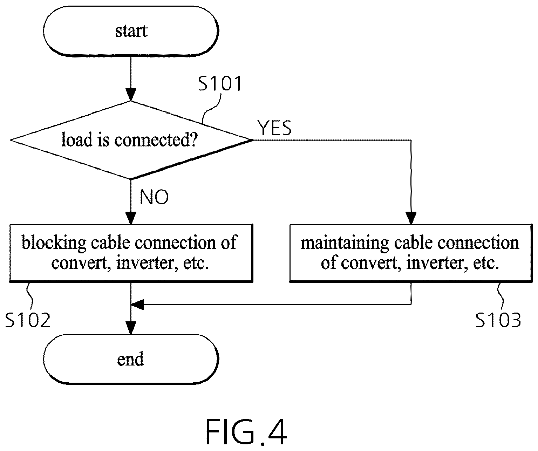

In addition, the control unit 120 also checks whether a load is connected to the power output unit 170 to block or maintain an internal cable connection (for example, DC-DC converter, an AC-DC converter, an inverter, etc.) of the portable energy storage device according to the present embodiment through the cable connection switching unit (190 in FIG. 2) (see FIG. 4).

Herein, the BMS control performed by the control unit 120 includes overcharge prevention function, overdischarge prevention function, overcurrent prevention function, cell balancing function, and temperature sensing function of the battery pack 150. The control unit 120 may include a sensor (not shown) for detecting information related to the functions.

The battery interface unit 130 is an interface for further connecting an additional battery pack, or an auxiliary battery pack, in addition to the portable energy storage device according to the present embodiment. For example, the auxiliary battery pack may be further connected and charged, or the charged auxiliary battery pack is additionally connected to be discharged (output) to the load.

The inverter unit 160 may generate a pure sine wave AC (for example, 110 VAC, 220 VAC, etc.) from the input DC power source.

The control unit 120 may control the operation of the inverter unit 160.

Also, the control unit 120 may include an information input/output unit (180 in FIG. 2) for outputting operation state information of the portable energy storage device according to the present embodiment. When the user selects desired operation state information using a button or a switch, the information input/output unit (180 in FIG. 2) outputs the selected operation state information.

The information input/output unit (180 in FIG. 2) may selectively use an LCD, a seven-segment (FND), and an LED (LED) for outputting the information.

In addition, the control unit 120 uses feedback control to control the inverter unit 160. Herein, the elements constituting the power supply circuit including the inverter unit 160 have tolerances caused due to the manufacturing process and environmental factors, and the output of the power supply circuit has a specific distribution due to the tolerance of the elements. Therefore, feedback control is essential because the output distribution of the power supply circuit must be within the specified range.

Meanwhile, a secondary battery (i.e., a battery pack) that is fundamentally built in the portable energy storage device according to the present embodiment can be detachably installed, thereby facilitating installation of the auxiliary battery module.

The communication unit 140 includes a wireless Internet module.

For example, the communication unit 140 accesses the Internet through a mobile communication network (e.g., LTE, etc.), and provides an Internet access service to peripheral devices connected via a WiFi. However, the communication unit 140 is not limited to WiFi, and may provide the Internet access service using another communication method (for example, Bluetooth).

For reference, the portable energy storage device according to the present embodiment enables the operations of a location based service (LBS) (e.g., utilized for prevention of theft by determining the state of connection of smart phone with ESS, as well as prevention of missing child and prevention of accidents by determining the connection position in real time), home network (e.g., providing file sharing between users in a group through data transfer using a home gateway and entertainment functions through the file sharing using the home gateway), and IoT (e.g., providing the user with information such as ESS status, inside/outside temperature/humidity, etc., through ambient environment sensing, providing convenience to the user by turning a LED light on when the surroundings are dark, and controlling the power of ESS by using smart phone), through wireless Internet access service home networking.

In addition, an application (e. g., Management APP) installed in a portable terminal (e. g., a smart phone, a tablet PC, etc.) of the user may manage an energy storage system (ESS) capable of being connected to the smart phone, monitor and control state information on the ESS, provide location information on the ESS and terminals thereto, and provide additional services through surrounding environment sensing.

Meanwhile, the BMS control function will be described in more detail. The control unit 120 monitors the voltage, current, and temperature charged/discharged in the battery as a battery monitoring function and performs SOC and SOH functions.

Here, a state of charge (SOC) is defined to indicate the battery charge status in %, a state of health (SOH) is defined to evaluate the level of the battery capacity degraded to date, and a state of life (SOL) is defined to estimate the remaining life of the battery before the battery's total capacity has faded.

In addition, the control unit 120 performs protection functions such as overcharge prevention and management for safety of the battery, and turns off an external switch (not shown) during overdischarge, overcurrent, and short circuit, and performs system diagnosis and data history management functions.

Also, in the present embodiment, the battery pack 150 should be designed with a heat sink (not shown) for maximizing heat dissipation and diffusion in consideration of heat dissipation. Generally, since a modular battery pack with dozens to hundreds of cells generates much heat inside, the battery pack may explode during operation or undergo electrolyte leakage when the heat-resistant structure is poorly designed. Accordingly, the design of the heat sink is very important to stability of the battery as well as life of the battery. For reference, rapid charging and discharging puts stress on the battery, which causes heat generation and, at the same time, deteriorates the life of the battery and generates the heat due to contact resistance.

FIG. 2 is an exemplary view illustrating a schematic configuration of a portable energy storage device according to a second embodiment of the present invention.

As shown in FIG. 2, the portable energy storage device according to the second embodiment further includes an information input/output unit 180 and a cable connection switching unit 190 in FIG. 1.

The information input/output unit 180 includes a button or a switch as a means through which the user receives desired operation state information, and includes a LCD, seven-segment (FND), and LED as a means for outputting operation state information selected through the button or the switch.

In addition, the cable connection switching unit 190 checks whether a load is connected to the power output unit 170 under control of the control unit 120 to block or maintain cable connections (e.g., DC-DC converter, AC-DC converter, inverter, etc.) of the portable energy storage device according to this embodiment.

The internal cable connection (e.g., cable connection of a DC-DC converter, an AC-DC converter, an inverter, or the like) of the portable energy storage device according to the present embodiment is blocked or maintained through the cable connection switching unit 190, thereby improving safety.

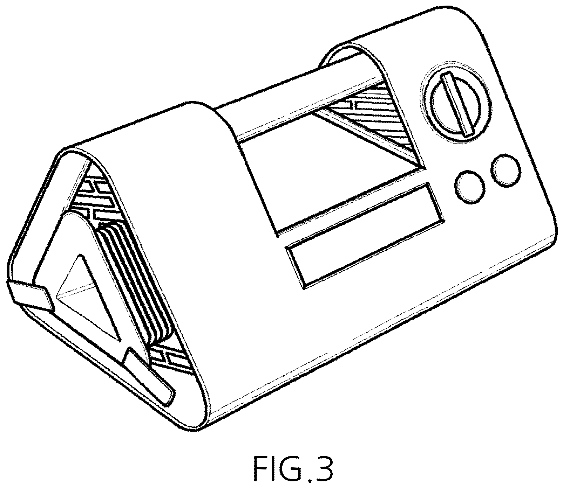

FIG. 3 is an exemplary view illustrating a schematic external appearance of a portable energy storage device according to an embodiment of the present invention.

As shown in FIG. 3, the portable energy storage device according to the present embodiment is configured to be formed in a triangular prism shape to maintain a stable state without shaking, to have a handle formed on the top, and to include at least one input means (e.g., a button or a switch for selecting an operation or an operation state display) and an output means for outputting operation state information (e.g., a LCD, a seven-segment (FND), or an LED (LED)) provided on one side.

In addition, the portable energy storage device has a cable for connecting an input power source or an output load built on the other side.

Meanwhile, it should be noted that the portable energy storage device shown in FIG. 3 is shown for the sake of understanding of the present embodiment, and is not intended to limit a shape thereof.

FIG. 4 is a flowchart illustrating an operation of blocking or maintaining a cable connection according to whether a control unit is connected to a load in FIG. 2.

As shown in FIG. 4, the control unit 120 confirms whether a load is connected to the power output unit 170 (S101).

When it is determined that the load is not connected to the power output unit 170 as a result of the confirmation (S101) (NO in S101), the control unit 120 controls the cable connection switching unit 190 to block the cable connection (e.g., cable connection of a DC-DC converter, AC-DC converter, inverter, etc.) in the portable energy storage device according to this embodiment.

Meanwhile, when it is determined that the load is connected to the power output unit 170 as a result of the confirmation (S101) (YES in S101), the control unit 120 controls the cable connection switching unit 190, to maintain the cable connection (e.g., cable connection of a DC-DC converter, an AC-DC converter, an inverter, etc.) in the portable energy storage device according to this embodiment.

As described above, the present embodiment has an effect of preventing consumption of the battery by blocking connection of an internal specific cable (for example, a cable of inverter) according to whether or not the load is connected.

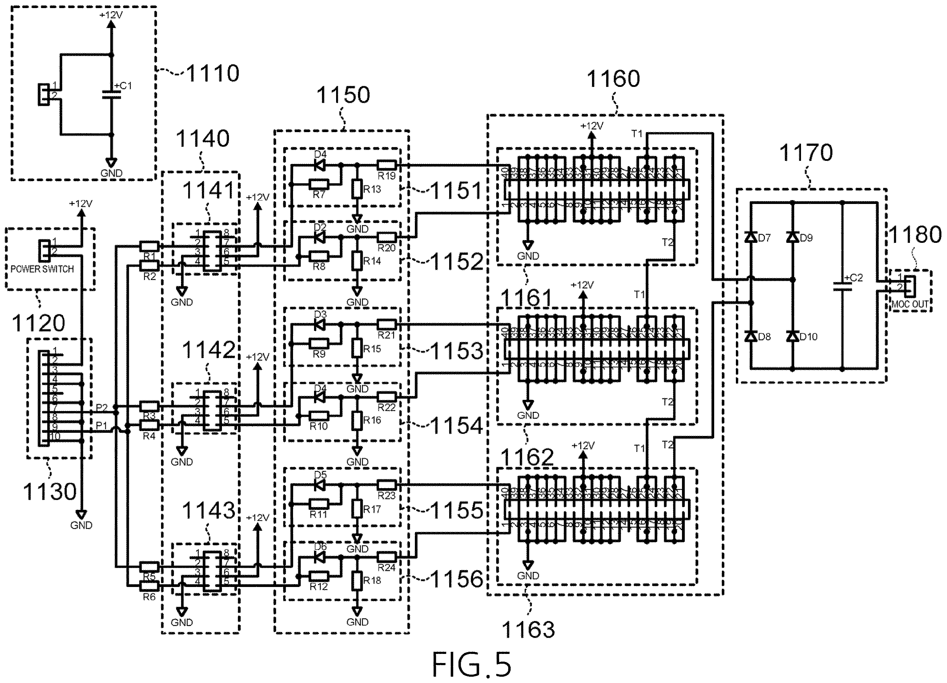

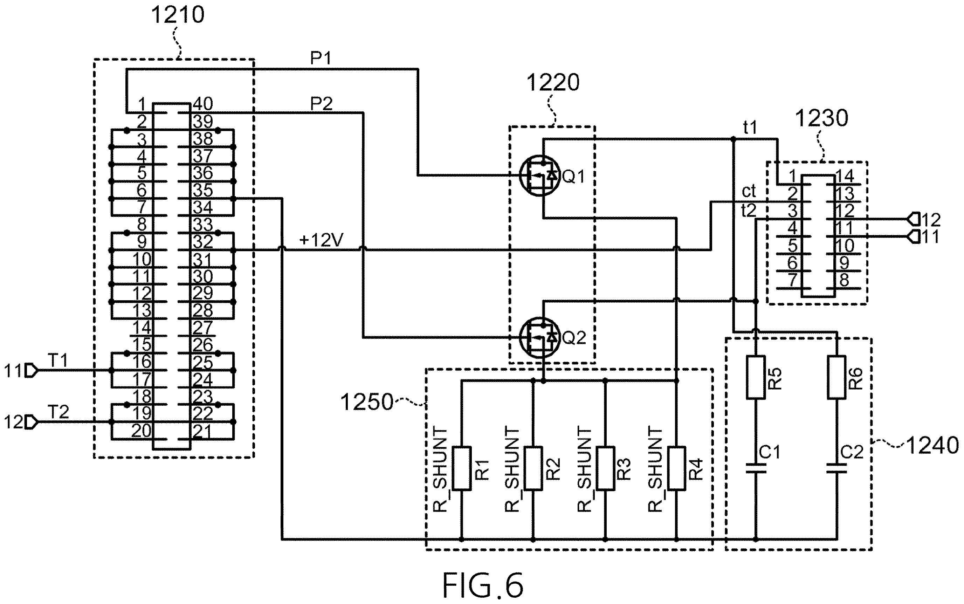

Hereinafter, the energy level conversion circuit in the present embodiment corresponds to a DC-DC converter circuit in a portable energy storage device, and the energy level conversion circuit for the portable energy storage device will be described in detail with reference to FIGS. 5 and 6.

FIG. 5 is an exemplary view illustrating a motherboard (or main board) circuit in an energy level conversion circuit for a portable energy storage device according to an embodiment of the present invention; and FIG. 6 is an exemplary view illustrating sub-board circuits (or converter boards) inserted in a plurality of female connectors (or slots) formed on a motherboard in FIG. 5.

Referring to FIG. 5, the motherboard (or main board) circuit includes a battery power input unit 1110, a power switching unit 1120, a switching pulse generating unit 1130, a current buffer unit 1140, a current limiting unit 1150, a female connector unit 1160, a rectifying unit 1170, and a boosting power output unit 1180.

The battery power input unit 1110 receives the battery power and removes noise, thereby outputting a stable battery power (for example, +12V). The stable battery power source (for example, +12V) in which the noise is removed is used as a power source for driving the energy level conversion circuit according to this embodiment.

The stable battery power (for example, +12 V) in which the noise is removed through the battery power input unit 1110 is controlled on and off through the power switch unit 1120. That is, the power switch unit 1120 inputs or blocks the power to the energy level conversion circuit of this embodiment in accordance with the user's selection.

The switching pulse generating unit 1130 includes a pair of switching pulses (that is, switching pulses in which the switching on and off intervals are opposite to each other) P1 and P2 for driving the switching unit 1220 of the sub-board (or converter board) circuit shown in FIG. 6.

Herein, the pair of switching pulses P1 and P2 is a square wave pulse controlled by a pulse width modulation (PWM) method. In order to control the pulse width of the pair of switching pulses P1 and P2, the current value (i.e., the current value converted into the voltage through the shunt resistor and then output) detected through the current monitoring unit 1250 of the sub-board circuit shown in FIG. 6 may be referred to.

The pair of switching pulses P1 and P2 generated by the switching pulse generating unit 1130 is applied to the sub-board circuits inserted into the respective female connectors 1161 to 1163 of the female connector unit 1160 formed on the motherboard.

The current buffer unit 1140 reduces the influence of external noise on the pair of switching pulses P1 and P2 output from the switching pulse generating unit 1130.

The current buffer unit 1140 includes a plurality of current buffers 1141 to 1143 that buffer a pair of switching pulses P1 and P2 respectively applied to the plurality of female connectors 1161 to 1163 of the female connector unit 1160.

The current limiting unit 1150 controls the influences of the pair of switching pulses P1 and P2 outputted from the switching pulse generating unit 1130 on the respective switches Q1 and Q2 of the switching unit 1220 of the sub-board circuit shown in FIG. 6.

For example, when the switching pulse is high, the current limiting units 1150 to 1156 cause the pulse to be applied to the respective switches Q1 and Q2 through a resistor, and when the switching pulse is low, the current limiting units 1150 to 1156 cause the voltage charged in the gates of the respective switches Q1 and Q2 to be dissipated through the diode and prevent the excessive current from being applied to the gates of the respective switches Q1 and Q2.

The current limiting unit 1150 includes a plurality of current limiting circuits 1151 to 1156 for limiting the respective switching pulses applied to the plurality of female connectors 1161 to 1163 of the female connector unit 1160.

The female connector unit 1160 includes a plurality of female connectors 1161 to 1163 into which the sub-board circuit shown in FIG. 6 is inserted.

Herein, the respective female connectors 1161 to 1163 includes a terminal receiving each of the pair of switching pulses P2 and P2, a terminal receiving the battery power (for example, +12V), a ground terminal GND, and secondary-side transformer connection terminals T1 and T2.

Here, the plurality of secondary-side trans-tap connection terminals is implemented in a serial connection manner. That is, the secondary-side first trans-tap connection terminal T1 of the first female connector 1161 is connected to the first input terminal of the rectifying unit 1170; the secondary-side second trans-tap connection terminal T2 of the first female connector 1161 is connected to the secondary-side first trans-tap connection terminal T1 of the second female connector 1162; the secondary-side second trans-tap connection terminal T2 of the second female connector 1162 is connected to the secondary-side first trans-tap connection terminal T1 of the third female connector 1163; and the secondary-side second trans-tap connection terminal T2 of the third female connector 1163 is connected to the second input terminal of the rectifying unit 1170.

As described above, the plurality of secondary-side trans-tap connection terminals T1 and T2 are implemented in a serial connection manner, thereby enabling boosting the level of the voltage (i.e., energy). However, it should be noted that although not shown in the drawings, the plurality of secondary-side trans-tap connection terminals T1 and T2 may be implemented in a parallel connection manner to increase the current. That is, a plurality of secondary-side trans-tap connection terminals T1 and T2 of the respective female connectors 1161 to 1163 may be connected to the same input terminal of the rectifying unit 1170.

For example, assuming that each of the sub-board circuits shown in FIG. 6 connected to (or inserted into) the respective female connectors 1161 to 1163 of the female connector unit 1160 is a 200W converter circuit, when all three sub-board circuits are connected to the board circuit shown in FIG. 5, it is possible to realize a total of 600W converter.

Unlike a case that the sub-boards shown in FIG. 6 are connected (inserted) to all of the respective connector units 1161 to 1163, when the sub-boards shown in FIG. 6 are connected (inserted) only to one or two of the female connectors, and the female connectors to which the sub-board circuit is not connected (inserted) are directly connected to the plurality of secondary-side trans-tap connection terminals T1 and T2 using a jump line, it is possible to perform easy change into a desired power (or energy) level (that is, a level corresponding to the number of the sub-board circuits connected to the respective female connectors).

Although not shown in the drawings, when the number of the female connectors connected in serial is increased to connect the sub-board circuits, it is possible to further expand the power (or energy) level (i.e., the level corresponding to the number of sub-board circuits connected to the respective female connectors).

The rectifying unit 1170 has a first input terminal connected to the secondary-side first trans-tap connection terminal T1 of the first female connector 1161 and a second input terminal connected to the secondary-side second trans-tap connection terminal T2 of the third female connector 1163.

Accordingly, the rectifying unit 1170 performs full-wave rectification on the voltage outputted through the secondary-side first trans-tap connection terminal T1 of the first female connector 1161 and the secondary-side second trans-tap connection T2 of the third female connector 1163, and finally outputs the direct current power source that is converted (i.e., boosted) in level by the sub-board circuit through the boosting power output unit 1180.

Although not shown in the drawings, the direct current power output through the boosting power output unit 1180 is applied to an inverter unit (not shown) and converted into an alternating current power.

Referring to FIG. 6, the sub-board circuit includes a male connector unit 1210, a switching unit 1220, a transformer 1230, a snubber circuit 1240, and a current monitoring unit 1250.

The male connector unit 1210 serves to connect (insert) the sub-board circuit to the respective female connectors 1161 to 1163 of the female connector unit 1160.

The switching unit 1220 includes switching transistors Q1 and Q2 (e.g., MOS transistors) that are turned on and off by a pair of switching pulses P1 and P2 applied from the motherboard circuit received from a gate thereof.

The respective switching transistors Q1 and Q2 have one side (e.g., a drain) connected to the primary-side first transformer t1 and the primary-side second transformer t2 of the transformer 1230, respectively and the other side (e.g., a source) grounded.

Accordingly, as the switching transistors Q1 and Q2 are turned on and off, the battery power (+12V) applied to the primary-side center tap ct of the transformer 1230 flows through the first switching transistor Q1 or the second switching transistor Q2.

Herein, the respective switching transistors Q1 and Q2 has a snubber circuit 1240 (that is, a circuit in which a resistor and a capacitor are connected in series) connected to one side (e.g., drain) thereof, so that counter electromotive force (i.e., counter electromotive force generated higher than the breakdown voltage of the switching transistor) generated at the end of the coil decreases when the current to the transformer 1230 is cut off, thereby preventing breakage of the switching transistors Q1 and Q2.

The respective switching transistors Q1 and Q2 has a current monitoring unit 1250 formed on the other side (e.g., a source) thereof.

The transformer 1230 applies a power source (for example, +12 V) to the primary-side center tap ct, allows the power applied to the center tap ct to be flowed through the primary-side first trans-tap t1 and the primary-side second trans-tap t2, and outputs a full-wave voltage through the secondary-side first trans-tap connection terminal T1 and the secondary-side second trans-tap connection terminal T2.

Accordingly, the sub-board circuit shown in FIG. 6 outputs the power source transformed by the transformer 1230 through the secondary-side trans-tap connection terminals T1 and T2 as the switching transistors Q1 and Q2 of the switching unit 1220 are turned on or off by a pair of switching pulses P1 and P2 applied by the motherboard circuit shown in FIG. 5. The sub-board circuit is serially connected through the female connector unit 1160 of the motherboard circuit shown in FIG. 5, so that the direct current power supply that is boosted (converted in level) by the number of the sub-board circuits is outputted through the motherboard circuit shown in FIG. 5.

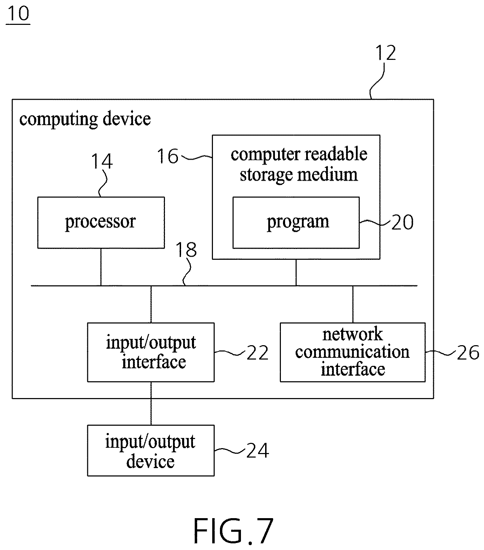

FIG. 7 is a block diagram illustrating a computing environment 10 including a computing device suitable for use in the exemplary embodiments. In the illustrated embodiment, each of the components may have different functions and capabilities than those described below, and may include additional components in addition to those described below.

The illustrated computing environment 10 includes a computing device 12. In one embodiment, the computing device 12 may be a portable energy storage device, or one or more components included in the portable energy storage device.

The computing device 12 includes at least one processor 14, a computer readable storage medium 16, and a communications bus 18. The processor 14 may cause the computing device 12 to operate in accordance with the exemplary embodiments discussed above. For example, the processor 14 may execute one or more programs stored on computer readable storage medium 16. The one or more programs may include one or more computer-executable instructions, and the computer-executable instructions cause the computing device 12 to perform operations in accordance with the illustrative embodiment when executed by the processor 14.

The computer-readable storage medium 16 is configured to store computer-executable instructions or program code, program data, and/or other suitable forms of information. The program 20 stored in the computer-readable storage medium 16 includes a set of instructions executable by the processor 14. In one embodiment, the computer-readable storage medium 16 may be any type of storage medium such as a memory (volatile memory such as random access memory, non-volatile memory, or any suitable combination thereof), one or more magnetic disk storage devices, optical disc storage devices, flash memory devices, any other form of storage medium capable of being accessed by the computing device 12 and storing the desired information, or any suitable combination thereof.

The communication bus 18 interconnects various other components of the computing device 12, including processor 14 and computer readable storage medium 16.

The computing device 12 may also include one or more input/output interfaces 22 and one or more network communication interfaces 26 that provide an interface for one or more input/output devices 24. The input/output interface 22 may include a scroll screen 102, an interface 104, an input screen 105, and the like. The input/output interface 22 and the network communication interface 26 are connected to the communication bus 18. The input/output device 24 may be connected to other components of the computing device 12 via the input/output interface 22. The exemplary input and output device 24 may be any type of device, such as a pointing device (such as a mouse or trackpad), a keyboard, a touch input device (such as a touch pad or touch screen), a voice or sound input device, an input device, and/or an output device such as a display device, a printer, a speaker, and/or a network card. The exemplary input and output device 24 may be included within the computing device 12 as a component of the computing device 12 and may be coupled to the computing device 102 as a separate device distinct from the computing device 12.

## Claims

1. An energy level conversion circuit for a portable energy storage device, the energy level conversion circuit comprising
a motherboard circuit, the mother board circuit including:
i) a female connector unit (1160) in which one or more female connectors are formed, wherein the motherboard circuit is adapted to receive a direct current power and to output the power obtained by boosting an energy level thereof into a specified energy level through an output unit formed in the motherboard circuit;
wherein the mother board circuit further including ii) a plurality of sub-board circuits, each sub-board circuit including a) a male connector unit (1210) comprising one or more male connectors and,
- b) a switching unit (1220) having a plurality of switching transistors (Q1 and Q2) turned on and off by receiving a pair of switching pulses (P1 and P2) applied from the motherboard circuit, and
c) a transformer (1230),
the mother board circuit being further adapted to output a power source transformed by the transformers (1230) of the sub-board circuits through secondary-side trans-tap connection terminals (T1 and T2) of the female connector unit (1160) as the switching transistors (Q1 and Q2) are turned on and off, and
**characterized in that** the plurality of sub-board circuits are connected to the female connector unit through the one or more female connectors and the one or more male connectors, and
wherein the sub-board circuits are connected in serial through the female connector unit (1160) of the motherboard circuit, so that energy level output from the mother board circuit is varied according to the number of the sub-board circuits.

2. The circuit of claim 1, wherein the motherboard circuit includes a switching pulse generating unit configured for generating the pair of switching pulses (P1 and P2), and the switching pulses have opposite switching on and off intervals to each other to switch the switching transistors (Q1 and Q2) in an alternating manner.

3. The circuit of claim 2, wherein the pair of switching pulses (P1 and P2) are configured to be applied to the sub-board circuits connected to the respective female connectors, and the respective female connectors include terminals to which the pair of switching pulses (P1 and P2) is configured to be input, a terminal to which a battery power is configured to be input, and the secondary-side trans-tap connection terminals (T1 and T2).

4. The circuit of claim 3, wherein the secondary-side trans-tap connection terminals (T1 and T2) are connected in series through the female connector of the motherboard circuit, and
a secondary-side first trans-tap connection terminal (T1) of a first female connector of the plurality of female connectors is connected to a first input terminal of a rectifying unit formed in the motherboard circuit; a secondary-side second trans-tap connection terminal of the first female connector is connected to a secondary-side first trans-tap connection terminal (T1) of a second arm connector; a secondary-side second trans-tap connection terminal (T2) of the second female connector is connected to a secondary-side first trans-tap connection terminal (T1) of a third female connector; and a secondary-side second trans-tap connection terminal (T2) of the third female connector is connected to a second input terminal of the rectifying unit.

5. The circuit of claim 4, wherein the rectifying unit is configured to perform full-wave rectification of a voltage output through the secondary-side first trans-tap connection terminal (T1) of the first female connector and the secondary-side second trans-tap connection terminal (T2) of the third female connector and to output the direct current power converted in energy level by the sub-board circuits.

6. The circuit of claim 4, wherein the pair of switching pulses (P1 and P2) are configured to be applied to gates of the respective switching transistors (Q1 and Q2), and a snubber circuit is connected to drains of the respective switching transistors (Q1 and Q2).

7. The circuit of claim 6, wherein the respective switching transistors (Q1 and Q2) are MOS transistors, in which the drains of the respective switching transistors (Q1 and Q2) are connected to a primary-side first trans-tap (t1) and a primary-side second trans-tap (t2) of the transformer, respectively, and sources of the respective switching transistors (Q1 and Q2) are grounded.

8. The circuit of claim 1, wherein the transformer is configured to apply battery power to a primary-side center tap (ct) of the transformer, and to allow a battery power applied to the center tap (ct) through a primary-side first trans-tap (t1) and a primary-side second trans-tap (t2) of the transformer to be flowed through a first switching transistor (Q1) or a second switching transistor (Q2), to output full-wave voltage through a secondary-side first trans-tap connection terminal (T1) of the female connector and a secondary-side second trans-tap connection terminal (T2) of the female connector.

## Patentansprüche

1. Energieniveaukonvertierungsschaltkreis für eine tragbare Energiespeichervorrichtung, wobei der Energieniveaukonvertierungsschaltkreis umfasst:
einen Motherboard-Schaltkreis, wobei der Motherboard-Schaltkreis umfasst:
(i) eine weibliche Verbindereinheit (1160), in der eine oder mehrere weibliche Verbinder gebildet sind, wobei der Motherboard-Schaltkreis dazu ausgelegt ist, eine Gleichstromleistung zu empfangen und die erhaltene Leistung auszugeben, indem ihr Energieniveau durch eine in dem Motherboard-Schaltkreis gebildete Ausgabeeinheit auf ein spezifiziertes Energieniveau gesteigert wird;
wobei der Motherboard-Schaltkreis ferner ii) eine Vielzahl von Subboard-Schaltkreisen umfasst, wobei jeder Subboard-Schaltkreis a) eine männliche Verbindereinheit (1210), die einen oder mehrere männliche Verbinder umfasst, und b) eine Umschalteinheit (1220), die eine Vielzahl von Umschalttransistoren (Q1 und Q2) aufweist, die durch das Empfangen eines Paars von Umschaltimpulsen (P1 und P2), die von dem Motherboard-Schaltkreis angelegt werden, ein- und ausgeschaltet werden, und c) einen Transformator (1230) umfasst,
wobei der Motherboard-Schaltkreis ferner dazu ausgelegt ist, eine durch die Transformatoren (1230) der Subboard-Schaltkreise transformierte Leistungsquelle durch sekundärseitige Trans-Tap-Verbindungsanschlüsse (T1 und T2) der weiblichen Verbindereinheit (1160) auszugeben, wenn die Umschalttransistoren (Q1 und Q2) ein- und ausgeschaltet werden, und
**dadurch gekennzeichnet, dass** die Vielzahl von Subboard-Schaltkreisen mit der weiblichen Verbindereinheit durch den einen oder die mehreren weiblichen Verbinder und den einen oder die mehreren männlichen Verbinder verbunden ist; und
wobei die Subboard-Schaltkreise durch die weibliche Verbindereinheit (1160) des Motherboard-Schaltkreises in Reihe geschaltet sind, so dass die Energieniveauausgabe von dem Motherboard-Schaltkreis gemäß der Anzahl der Subboard-Schaltkreise variiert ist.

2. Schaltkreis nach Anspruch 1, wobei der Motherboard-Schaltkreis eine Umschaltimpuls-Erzeugungseinheit umfasst, die zum Erzeugen des Paars von Umschaltimpulsen (P1 und P2) konfiguriert ist, und
die Umschaltimpulse einander entgegengesetzte Ein- und Ausschaltintervalle aufweisen, um die Umschalttransistoren (Q1 und Q2) auf abwechselnde Weise zu schalten.

3. Schaltkreis nach Anspruch 2, wobei das Paar von Umschaltimpulsen (P1 und P2) dazu konfiguriert ist, an die Subboard-Schaltkreise angelegt zu werden, die mit den jeweiligen weiblichen Verbindern verbunden sind, und
die jeweiligen weiblichen Verbinder Anschlüsse, an denen das Paar von Umschaltimpulsen (P1 und P2) dazu konfiguriert ist, eingegeben zu werden, einen Anschluss, an dem eine Batterieleistung dazu konfiguriert ist, eingegeben zu werden, und die sekundärseitigen Trans-Tap-Verbindungsanschlüsse (T1 und T2) umfassen.

4. Schaltkreis nach Anspruch 3, wobei die sekundärseitigen Trans-Tap-Verbindungsanschlüsse (T1 und T2) durch den weiblichen Verbinder des Motherboard-Schaltkreises in Reihe geschaltet sind, und
ein erster sekundärseitiger Trans-Tap-Verbindungsanschluss (T1) eines ersten weiblichen Verbinders der Vielzahl von weiblichen Verbindern mit einem ersten Eingabeanschluss einer in dem Motherboard-Schaltkreis gebildeten Gleichrichtereinheit verbunden ist; ein zweiter sekundärseitiger Trans-Tap-Verbindungsanschluss des ersten weiblichen Verbinders mit einem ersten sekundärseitigen Trans-Tap-Verbindungsanschluss (T1) eines zweiten weiblichen Verbinders verbunden ist; ein zweiter sekundärseitiger Trans-Tap-Verbindungsanschluss (T2) des zweiten weiblichen Verbinders mit einem ersten sekundärseitigen Trans-Tap-Verbindungsanschluss (T1) eines dritten weiblichen Verbinders verbunden ist; und ein zweiter sekundärseitiger Trans-Tap-Verbindungsanschluss (T2) des dritten weiblichen Verbinders mit einem zweiten Eingabe-Anschluss der Gleichrichtereinheit verbunden ist.

5. Schaltkreis nach Anspruch 4, wobei die Gleichrichtereinheit dazu konfiguriert ist, Vollwellen-Gleichrichtung eines Spannungsausgangs durch den ersten sekundärseitigen Trans-Tap-Verbindungsanschluss (T1) des ersten weiblichen Verbinders und den zweiten sekundärseitigen Trans-Tap-Verbindungsanschluss (T2) des dritten weiblichen Verbinders durchzuführen und die im Energieniveau konvertierte Gleichstromleistung durch die Subboard-Schaltkreise ausgeben.

6. Schaltkreis nach Anspruch 4, wobei das Paar von Umschaltimpulsen (P1 und P2) dazu konfiguriert ist, an Gates der jeweiligen Umschalttransistoren (Q1 und Q2) angelegt zu werden, und
ein Snubber-Schaltkreis mit Drains der jeweiligen Umschalttransistoren (Q1 und Q2) verbunden ist.

7. Schaltkreis nach Anspruch 6, wobei die jeweiligen Umschalttransistoren (Q1 und Q2) MOS-Transistoren sind, bei denen die Drains der jeweiligen Umschalttransistoren (Q1 und Q2) mit einem ersten primärseitigen Trans-Tap (t1) bzw. einem zweiten primärseitigen Trans-Tap (t2) des Transformators verbunden sind, und die Quellen der jeweiligen Umschalttransistoren (Q1 und Q2) geerdet sind.

8. Schaltkreis nach Anspruch 1, wobei der Transformator dazu konfiguriert ist, Batterieleistung an einen primärseitigen Zentral-Tap (ct) des Transformators anzulegen, und zu erlauben, dass eine Batterieleistung, die durch einen ersten primärseitigen Trans-Tap (t1) und einen zweiten primärseitigen Trans-Tap (t2) des Transformators an den Zentral-Tap (ct) angelegt wird, durch einen ersten Umschalttransistor (Q1) oder einen zweiten Umschalttransistor (Q2) strömen gelassen wird, um Vollwellen-Spannung durch einen ersten sekundärseitigen Trans-Tap-Verbindungsanschluss (T1) des weiblichen Verbinders und einen zweiten sekundärseitigen Trans-Tap-Verbindungsanschluss (T2) des weiblichen Verbinders auszugeben.

## Revendications

1. Circuit de conversion du niveau d'énergie pour un dispositif portable de stockage d'énergie, le circuit de conversion du niveau d'énergie comprenant un circuit de carte mère, le circuit de carte mère incluant :
une unité de connecteur femelle (1160) dans laquelle un ou plusieurs connecteurs femelles sont formés, où le circuit de carte mère est adapté à recevoir de l'énergie en courant continu et à émettre l'énergie obtenue en augmentant un niveau d'énergie de celui-ci dans un niveau d'énergie spécifié à travers une unité d'émission formée dans le circuit de carte mère,
où le circuit de carte mère inclut en outre une pluralité de circuits de sous-cartes, chaque circuit de sous-carte incluant
a) une unité de connecteur mâle (1210) comprenant un ou plusieurs connecteurs mâles et,
b) une unité de basculement (1220) présentant une pluralité de transistors de basculement (Q1 et Q2) allumés et éteints en recevant une paire de pulses de basculement (P1 et P2) appliquée depuis le circuit de carte mère et
c) un transformateur (1230),
le circuit de carte mère étant en outre adaptée à émettre une source d'énergie transformée par les transformateurs (1230) des circuits de sous-carte à travers des terminaux secondaires de connexion de prise robinet trans (T1 et T2) de l'unité de connecteur femelle (1130) tandis que les transistors de basculement (Q1 et Q2) sont allumés et éteints et
**caractérisé en ce que** la pluralité de circuits de sous-carte sont connectés à l'unité de connecteur femelle à travers le ou les connecteurs femelles et le ou les connecteurs mâles et
où les circuits de sous-carte sont connectés en série à travers l'unité de connecteur femelle (1160) du circuit de carte mère, de telle manière que l'émission de niveau d'énergie provenant du circuit de carte mère est variée en fonction du nombre de circuits de sous-carte.

2. Circuit selon la revendication 1, **caractérisé en ce que** le circuit de carte mère inclut une unité de génération de pulse de basculement configuré pour générer la paire de pulses de basculement (P1 et P2) et
les pulses de basculement ont des intervalles de basculement pour être allumés et éteints l'un par rapport à l'autre pour faire basculer les transistors de basculement (Q1 et Q2) de manière alternée.

3. Circuit selon la revendication 2, **caractérisé en ce que** la paire de pulses de basculement (P1 et P2) est configurée pour être appliquée aux circuits de sous-carte connecté aux connecteurs femelles respectifs et
les connecteurs femelles respectifs incluent des terminaux sur lesquels la paire de pulses de basculement (P1 et P2) est configurée pour être entrée, un terminal auquel l'énergie d'une batterie est configurée pour être entrée et les terminaux secondaires de connexion de prise robinet trans (T1 et T2).

4. Circuit selon la revendication 3, **caractérisé en ce que** les terminaux secondaires de connexion de prise robinet trans (T1 et T2) sont connectés en série à travers le connecteur femelle du circuit de carte mère et
un premier terminal secondaire de connexion de prise robinet trans (T1) d'un premier connecteur femelle de la pluralité de connecteurs femelles est connecté à un premier terminal d'entrée d'une unité de rectification formée dans le circuit de carte mère, un deuxième terminal secondaire de connexion de prise robinet trans du côté du premier connecteur femelle est connecté à un premier terminal secondaire de connexion de prise robinet trans (T1) d'un deuxième bras connecteur, un deuxième terminal secondaire de connexion de prise robinet trans (T2) du deuxième connecteur femelle est connecté à un troisième terminal secondaire de connexion de prise robinet trans (T1) d'un connecteur femelle, et un deuxième terminal secondaire de connexion de prise robinet trans (T2) du troisième connecteur femelle est connecté à un deuxième terminal d'entrée de l'unité de rectification.

5. Circuit selon la revendication 4, **caractérisé en ce que** l'unité de rectification est configurée pour réaliser une rectification en onde entière d'une sortie de tension à travers le premier terminal secondaire de connexion de prise robinet trans (T1) du premier connecteur femelle et le deuxième terminal secondaire de connexion de prise robinet trans (T2) du troisième connecteur femelle et pour émettre de l'énergie en courant continu convertie en niveau d'énergie par les circuits de sous-carte.

6. Circuit selon la revendication 4, **caractérisé en ce que** la paire de pulses de basculement (P1 et P2) sont configurés pour être appliqués aux portes des transistors de basculement respectifs (Q1 et Q2) et
un circuit autobloquant est connecté aux drains des transistors de basculement respectifs (Q1 et Q2).

7. Circuit selon la revendication 6, **caractérisé en ce que** les transistors de basculement respectifs (Q1 et Q2) sont des transistors MOS, dans lesquels les drains des transistors de basculement respectifs (Q1 et Q2) sont connectés à une première prise robinet trans primaire (t1) et une deuxième prise robinet trans primaire (t2) du transformateur, respectivement, et les sources des transistors de basculement respectifs (Q1 et Q2) sont liés à la terre.

8. Circuit selon la revendication 1, **caractérisé en ce que** le transformateur est configuré pour appliquer l'énergie d'une batterie à une prise robinet centrale primaire (ct) du transformateur et pour permettre l'application de l'énergie d'une batterie à la prise robinet centrale (ct) à travers une première prise robinet trans primaire (t1) et une deuxième prise robinet trans primaire (t2) du transformateur de circuler à travers un premier transistor de basculement (Q1) ou un deuxième transistor de basculement (Q2), pour sortir une tension en onde entière à travers un premier terminal de connexion secondaire de prise robinet trans (T1) du connecteur femelle et un deuxième terminal de connexion secondaire de prise robinet trans (T2) du connecteur femelle.
